# DEMANDE DE BREVET EUROPEEN

(11) **EP 3 828 521 A1**
(43) Date de publication de la demande: **02.06.2021**
(21) Numéro de dépôt: 20209476.9
(22) Date de dépôt: 24.11.2020
(51) Int. Cl.: G01J 5/04, H01L 27/14, G01J 5/02, H01L 21/02, H01L 23/26

(54) **PROCEDE DE FABRICATION D'UN DISPOSITIF DE DETECTION COMPORTANT UNE ETAPE DE COLLAGE DIRECT D'UNE COUCHE MINCE DE SCELLEMENT MUNIE D'UN MATERIAU GETTER**

(30) Priorité: 27.11.2019 FR 1913325
(71) Demandeur: COMMISSARIAT À L'ÉNERGIE ATOMIQUE ET AUX ÉNERGIES ALTERNATIVES, 75015 Paris (FR)
(72) Inventeur: BECKER, Sébastien, 38054 GRENOBLE cedex 09 (FR); FOURNEL, Frank, 38054 GRENOBLE cedex 09 (FR)
(74) Mandataire: INNOV-GROUP

(57) **Abrégé**

L'invention porte sur un procédé de fabrication d'un détecteur thermique (1) comportant les étapes suivantes :
∘ réalisation d'un premier empilement (10) comportant un détecteur thermique (20), une couche sacrificielle minérale (15) et une couche mince d'encapsulation (16) présentant un évent latéral (17.1) ;
∘ réalisation d'un deuxième empilement (30) comportant une couche mince de scellement (33) et une portion getter (34) ;
∘ suppression de la couche sacrificielle minérale (15) ;
∘ assemblage par collage direct de la couche mince de scellement (33) mise au contact de la couche mince d'encapsulation (16) et obturant l'évent latéral (17.1), la portion getter (34) étant situé dans l'évent latéral (17.1).
∘

## Description

### DOMAINE TECHNIQUE

Le domaine de l'invention est celui des dispositifs de détection de rayonnement électromagnétique, en particulier infrarouge ou térahertz, comportant au moins un détecteur thermique encapsulé dans une cavité hermétique, dans laquelle est également situé un matériau getter. L'invention s'applique notamment au domaine de l'imagerie infrarouge et de la thermographie.

### ÉTAT DE LA TECHNIQUE ANTÉRIEURE

Un dispositif de détection de rayonnement électromagnétique, par exemple infrarouge ou térahertz, peut comprendre une matrice de détecteurs thermiques comportant chacun une portion absorbante apte à absorber le rayonnement électromagnétique à détecter.

Dans le but d'assurer l'isolation thermique des détecteurs thermiques, les portions absorbantes se présentent habituellement sous la forme de membranes suspendues au-dessus du substrat par des piliers d'ancrage, et isolées thermiquement de celui-ci par des bras de maintien et d'isolation thermique. Ces piliers d'ancrage et bras d'isolation thermique présentent également une fonction électrique en reliant électriquement les membranes suspendues à un circuit de lecture généralement disposé dans le substrat.

Le circuit de lecture se présente habituellement sous la forme d'un circuit CMOS. Il permet l'application d'un signal de commande aux détecteurs thermiques ainsi que la lecture de signaux de détection générés par ces derniers en réponse à l'absorption du rayonnement électromagnétique à détecter. Le circuit de lecture comporte différents niveaux d'interconnexion électrique formés de lignes métalliques séparées les unes des autres par des couches diélectriques dites inter-métal. Au moins un plot de connexion électrique du circuit de lecture est disposé sur le substrat de telle manière qu'il puisse être contacté depuis l'extérieur du dispositif de détection.

Le document EP3239670A1 décrit un procédé de fabrication d'un dispositif de détection qui utilise des couches sacrificielles minérales pour réaliser les détecteurs thermiques, lesquelles sont ensuite supprimées par une gravure chimique humide. Une portion d'un matériau getter, par exemple en titane, est située sous chaque membrane absorbante, et est protégée de la gravure chimique humide par une couche mince sacrificielle carbonée, laquelle est ensuite supprimée par une gravure chimique sèche spécifique. Les couches sacrificielles minérales recouvrent donc momentanément la couche mince sacrificielle carbonée. Ce procédé nécessite donc de protéger le matériau getter, ici par la couche mince carbonée, qui peut être dégradé par la gravure chimique humide utilisée lors de la suppression des couches sacrificielles minérales. Il importe de plus de préserver la tenue mécanique de l'empilement obtenu lors des différentes étapes du procédé de fabrication, en particulier lorsque les étapes de planarisation des couches minces sacrificielles sont effectuées.

Le document EP3399290A1 décrit un autre procédé de fabrication d'un dispositif de détection, dans lequel la structure d'encapsulation qui définit la cavité hermétique est formée par report d'un capot fin. Plus précisément, un premier empilement est réalisé qui comporte les détecteurs thermiques ainsi que des piliers périphériques présentant une surface de scellement périphérique en un matériau métallique, par exemple en cuivre. Un deuxième empilement est réalisé, qui comporte une couche mince formant le capot fin munie d'une portion getter ainsi que d'une surface de scellement périphérique en un matériau métallique, par exemple en cuivre. Ce deuxième empilement est reporté sur le premier, et les surfaces de scellement périphérique sont mises en contact et collées l'une à l'autre. La portion getter est recouvert d'une couche de protection pour éviter sa dégradation lors d'une gravure chimique humide mise en œuvre pour supprimer les couches sacrificielles minérales. Dans ce procédé également, il est nécessaire de protéger le matériau getter de l'agent de gravure utilisé lors de la suppression des couches sacrificielles minérales. De plus, l'utilisation de cuivre pour assurer le collage des deux empilements peut complexifier le procédé de fabrication, dans la mesure où ce matériau peut ne pas être disponible dans certaines filières technologiques.

### EXPOSÉ DE L'INVENTION

L'invention a pour objectif de remédier au moins en partie aux inconvénients de l'art antérieur, et notamment de se libérer de la contrainte de devoir protéger le matériau getter lors de la gravure chimique humide mise en œuvre pour supprimer les couches sacrificielles minérales. Il est alors possible d'obtenir une structure d'encapsulation à face supérieure plane, ce qui est avantageux lorsqu'on souhaite y ajouter des composants optiques (filtres...).

Pour cela, l'objet de l'invention est un procédé de fabrication d'un dispositif de détection d'un dispositif de détection d'un rayonnement électromagnétique, comportant les étapes suivantes :
- réalisation d'un premier empilement comportant : un premier substrat ; au moins un détecteur thermique reposant sur le premier substrat, destiné à détecter le rayonnement électromagnétique, et recouvert par au moins une couche sacrificielle minérale réalisée en un matériau minéral apte à être supprimé par une gravure chimique ; une couche mince d'encapsulation, s'étendant au-dessus du détecteur thermique et participant à délimiter une cavité dans laquelle se situe le détecteur thermique, comportant une partie supérieure reposant sur la couche sacrificielle minérale ;
- réalisation d'au moins un évent dit latéral s'étendant au travers de la couche mince d'encapsulation, et étant distant du détecteur thermique dans un plan parallèle au plan du premier substrat ;
- suppression par la gravure chimique de la couche mince sacrificielle, celle-ci étant évacuée au travers de l'évent latéral.

Selon l'invention, le procédé de fabrication comporte les étapes suivantes :
- réalisation d'un deuxième empilement comportant : un substrat support ; une couche mince dite de scellement, transparente au rayonnement électromagnétique ; et au moins une portion getter disposée sur la couche mince de scellement et recouvrant partiellement celle-ci ;
- assemblage des premier et deuxième empilements, à la suite de l'étape de suppression, par mise en contact et collage direct de la couche mince de scellement sur la partie supérieure de la couche mince d'encapsulation, de sorte que la portion getter est située dans l'évent latéral, lequel est alors obturé par la couche mince de scellement.

Certains aspects préférés mais non limitatifs de ce procédé sont les suivants.

La couche mince d'encapsulation peut s'étendre continûment au-dessus et autour du détecteur thermique. Elle peut ainsi comporter la partie supérieure et une partie périphérique qui s'étend au-travers de la couche sacrificielle minérale et repose sur le premier substrat.

L'étape d'assemblage par collage direct peut être effectuée à température ambiante avec une pression de niveau de vide inférieure ou égale à 10-5 Pa.

Le premier empilement peut comporter une matrice de détecteurs thermiques situés dans la cavité, comportant une étape de réalisation d'une pluralité de deuxièmes évents de libération, la couche mince de scellement obturant également les deuxièmes évents de libération.

La couche mince d'encapsulation peut être réalisée à base de silicium, et la couche mince de scellement peut être réalisée à base de silicium ou de germanium.

La couche mince d'encapsulation peut présenter une surface de contact en silicium, et la couche mince de scellement peut présenter une surface de contact en silicium ou en germanium. L'étape d'assemblage par collage direct peut comporter une activation desdites surfaces de contact par gravure partielle par faisceau d'ions et un collage sous vide.

La partie supérieure de la couche mince d'encapsulation peut être formée d'une sous-couche réalisée en silicium et d'une première sous-couche métallique, et la couche mince de scellement peut être formée d'une sous-couche réalisée à base de silicium ou en germanium et d'une deuxième sous-couche métallique, les deux sous-couches métalliques étant transparentes au rayonnement électromagnétique à détecter. L'étape d'assemblage par collage direct peut comporter la mise en contact des deux sous-couches métalliques l'une contre l'autre sous vide.

Lesdites sous-couches métalliques peuvent présenter chacune une épaisseur inférieure ou égale à 1nm.

Lesdites sous-couches métalliques peuvent être réalisées en un matériau identique à celui de la portion getter.

Le premier empilement peut comporter plusieurs matrices de détecteurs thermiques, chaque matrice étant située dans une cavité distincte délimitée au moins en partie par une couche mince d'encapsulation, la couche mince de scellement venant au contact des parties supérieures des différentes couches minces d'encapsulation de manière à obturer les différents évents latéraux correspondants.

Le premier empilement peut comporter un plot latéral de renfort, formée d'une cavité latérale délimitée dans le plan parallèle au substrat par des parties périphériques de couches minces d'encapsulation adjacentes, et délimitée suivant l'axe orthogonal au premier substrat par une partie supérieure intercalaire reliant les parties supérieures des couches minces d'encapsulation adjacentes, ladite cavité latérale étant remplie par la couche sacrificielle minérale, renforçant ainsi la tenue mécanique des couches minces d'encapsulation lors de l'assemblage desdits empilements par collage direct.

Le plot latéral de renfort peut être supprimé après l'étape d'assemblage par collage direct, par gravure de la partie supérieure intercalaire et suppression par gravure chimique de la couche sacrificielle minérale située dans la cavité latérale.

La portion getter peut être située en regard d'un détecteur thermique dit de compensation destiné à ne pas recevoir le rayonnement électromagnétique, la portion getter étant opaque au rayonnement électromagnétique.

L'invention porte également sur un dispositif détection d'un rayonnement électromagnétique, comportant :
∘ un substrat ;
∘ au moins un détecteur thermique reposant sur le premier substrat, destiné à détecter le rayonnement électromagnétique ;
∘ une couche mince d'encapsulation, s'étendant au-dessus du détecteur thermique et participant à délimiter une cavité dans laquelle se situe le détecteur thermique, comportant une partie supérieure ;
∘ au moins un évent dit latéral s'étendant au travers de la couche mince d'encapsulation, et étant distant du détecteur thermique dans un plan parallèle au plan du substrat ;
∘ une couche mince de scellement, transparente au rayonnement électromagnétique, reposant au contact de la partie supérieure de la couche mince d'encapsulation, et obturant l'évent latéral, la couche mince de scellement présentant une face supérieure plane opposée au substrat ;
∘ au moins une portion getter assemblée à la couche mince de scellement et recouvrant partiellement celle-ci, et disposée dans l'évent latéral.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1F illustrent différentes étapes d'un procédé de fabrication d'un dispositif de détection selon un premier mode de réalisation dans lequel le collage direct est de type SAB (pour *Surface Activated Bonding,* en anglais) ;
les figures 2A à 2E illustrent différentes étapes d'un procédé de fabrication d'un dispositif de détection selon une variante du premier mode de réalisation, dans laquelle un plot latéral de renfort provisoire est présent lors du report du deuxième empilement ;
la figure 3 est une vue en coupe, schématique et partielle, d'un dispositif de détection obtenu selon une autre variante du premier mode de réalisation, dans laquelle la portion getter est disposée en regard d'un détecteur thermique de compensation ;
les figures 4A à 4C illustrent différentes étapes d'un procédé de fabrication d'un dispositif de détection selon un deuxième mode de réalisation dans lequel le collage direct est de type ADB (pour *Atomic Diffusion Bonding,* en anglais).

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif de détection de rayonnement électromagnétique adapté à détecter un rayonnement infrarouge ou térahertz. Ce dispositif de détection comporte un ou plusieurs détecteurs thermiques, ainsi qu'au moins un matériau à effet getter, situés dans une cavité hermétique. La cavité hermétique est délimitée par une structure d'encapsulation, laquelle est formée de plusieurs couches minces transparentes au rayonnement électromagnétique à détecter, dont notamment une couche mince d'encapsulation qui s'étend continûment au-dessus du ou des détecteurs thermiques, et éventuellement continûment au-dessus et autour de ces derniers. Par couche mince, on entend une couche formée par les techniques de dépôt de matériau de la microélectronique, dont l'épaisseur est de préférence inférieure ou égale à 10µm. Par ailleurs, une couche mince est dite transparente lorsqu'elle présente un coefficient de transmission pour une longueur d'onde centrale du rayonnement électromagnétique à détecter supérieur ou égal à 50%, de préférence à 75%, voire à 90%.

Selon l'invention, cette couche mince d'encapsulation comporte au moins un évent latéral, distant dans un plan parallèle au substrat vis-à-vis du ou des détecteurs thermiques destinés à recevoir le rayonnement électromagnétique. Cet évent latéral, ainsi que les éventuels autres évents de libération, sont obturés par une couche mince de scellement, laquelle a été assemblée par collage direct, ici de type SAB ou ADB, à la couche mince d'encapsulation. La portion getter est alors située à l'intérieur de la cavité, et s'étend au travers de l'évent latéral. Par obturer, on entend que la couche mince de scellement recouvre l'évent de sorte qu'il ne donne plus accès à la cavité à partir de l'extérieur de celle-ci. La couche mince de scellement rend ici hermétique la cavité en empêchant le transfert de gaz vers ou depuis la cavité. L'évent n'est ici pas rempli ou bouché entièrement par la couche mince de scellement dans la mesure où c'est une couche rapportée et non pas déposée sur la couche mince d'encapsulation, ce qui autorise la portion getter d'être situé dans l'évent, c'est-à-dire situé dans l'espace délimité dans le plan XY par la bordure de la partie supérieure de la couche mince d'encapsulation.

D'une manière générale, un matériau à effet getter est un matériau destiné à être exposé à l'atmosphère de la cavité hermétique et apte à réaliser un pompage gazeux par absorption et/ou adsorption. Il s'agit d'un matériau métallique qui peut être choisi parmi le titane, le zirconium, le vanadium, le chrome, le cobalt, le fer, le manganèse, le palladium, le baryum et/ou l'aluminium, voire un alliage de ces métaux tel que le TiZrV.

Par ailleurs, le collage direct *(direct bonding,* en anglais), ici de type SAB ou ADB, est la solidarisation de deux surfaces mises au contact l'une de l'autre, sans apport d'un matériau collant spécifique tel qu'une résine ou un polymère, mais par le biais des forces attractives d'interaction atomique entre les surfaces à coller avec des liaisons covalentes ou métalliques. Il s'agit d'un collage spontané à température ambiante. La température ambiante peut être une température inférieure ou égale à 40°C, par exemple égale à 25°C environ. Le collage direct peut être assisté en température et/ou en pression, de manière à augmenter l'énergie de collage et ainsi renforcer l'adhérence des surfaces et donc l'herméticité de la cavité, par exemple dans le cas où l'état de surface et la machine de collage ne permettent d'obtenir les performances attendues directement à température ambiante sans pression.

Par ailleurs, le procédé de fabrication comporte une étape de réalisation du ou des détecteurs thermiques au moyen d'au moins une couche sacrificielle dite minérale, réalisée en un matériau minéral ou inorganique. Il s'agit ici d'un matériau diélectrique à base de silicium permettant également la réalisation d'une couche diélectrique inter-métal du circuit de lecture, c'est-à-dire un matériau électriquement isolant, avec par exemple une constante diélectrique, ou permittivité relative, inférieure ou égale à 3,9, permettant de limiter la capacité parasite entre les interconnexions. Ce matériau minéral ne comporte pas de chaînes carbonées, et peut être un oxyde de silicium SiOx ou un nitrure de silicium SiₓN_{y}, voire un matériau organosilicié tel que du SiOC, du SiOCH, ou d'un matériau de type verre fluoré tel que du SiOF. La couche sacrificielle minérale peut être supprimée par une gravure chimique humide telle qu'une attaque chimique en milieu acide, par exemple à l'acide fluorhydrique en phase vapeur (HF vapeur). Par gravure humide, on entend d'une manière générale que l'agent de gravure se présente en phase liquide ou en phase vapeur, et ici, de préférence, en phase vapeur.

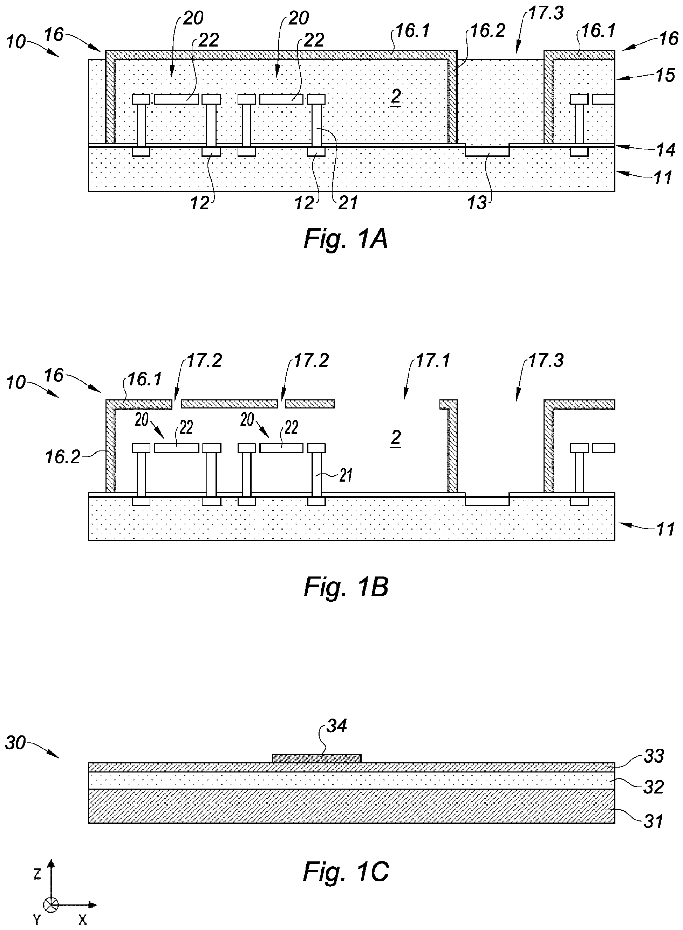

Les figures 1A à 1F illustrent différentes étapes d'un procédé de fabrication d'un dispositif de détection 1 selon un premier mode de réalisation dans lequel le collage direct est de type SAB *(Surface Activated Bonding).* Par souci de clarté, seule une partie du dispositif de détection 1 est représentée sur les figures. Dans cet exemple, le procédé permet de fabriquer de manière simultanée plusieurs dispositifs de détection 1 de préférence identiques entre eux. De plus, la couche mince d'encapsulation s'étend continûment au-dessus et autour des détecteurs thermiques. Cependant, d'autres configurations de la couche mince d'encapsulation sont possibles.

A titre d'exemple, les détecteurs thermiques 20 sont ici adaptés à détecter un rayonnement infrarouge dans la gamme LWIR *(Long Wavelength Infrared,* en anglais) dont la longueur d'onde est comprise entre 8µm et 14µm environ. Chaque dispositif de détection 1 comporte un ou plusieurs détecteurs thermiques 20, et ici une matrice de détecteurs thermiques 20 identiques, connectés à un circuit de lecture situé dans le substrat 11 (dit alors substrat de lecture), et situés dans une même cavité hermétique 2. Les détecteurs thermiques 20 forment ainsi des pixels sensibles agencés périodiquement, et peuvent présenter une dimension latérale dans le plan du substrat de lecture 11, de l'ordre de quelques dizaines de microns, par exemple égale à 10µm environ voire moins.

On définit ici et pour la suite de la description un repère direct tridimensionnel XYZ, où le plan XY est sensiblement parallèle au plan du substrat de lecture 11, l'axe Z étant orienté suivant une direction sensiblement orthogonale au plan du substrat de lecture 11 en direction des détecteurs thermiques 20. Les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X,Y). Par ailleurs, les termes « inférieur » et « supérieur » s'entendent comme étant relatifs à un positionnement croissant lorsqu'on s'éloigne du substrat de lecture 11 suivant la direction +Z.

En référence à la fig.1A, on réalise un premier empilement 10 comportant :
- un premier substrat 11, dit substrat de lecture ;
- au moins une matrice de détecteurs thermiques 20 reposant sur le substrat de lecture 11, destinés à détecter le rayonnement électromagnétique, et recouverts par au moins une couche sacrificielle minérale 15 ;
- une couche mince d'encapsulation 16, s'étendant continûment au-dessus de la matrice de détecteurs thermiques 20 suivant l'axe Z et autour de celle-ci dans le plan XY.

Dans cet exemple, plusieurs matrices de détecteurs thermiques 20 reposent sur le substrat de lecture 11, et sont entourées chacune par une couche mince d'encapsulation 16 distincte. Chaque couche mince d'encapsulation 16 est destinée à délimiter une cavité 2 logeant ici une matrice de détecteurs thermiques 20.

Le substrat de lecture 11 est réalisé à base de silicium, et est formé d'un substrat support contenant le circuit de lecture (non représenté) adapté à commander et lire les détecteurs thermiques 20. Le circuit de lecture se présente ici sous la forme d'un circuit intégré CMOS. Il comporte entre autres des portions de lignes conductrices séparées les unes des autres par des couches isolantes inter-métal réalisées en un matériau diélectrique, par exemple un matériau minéral à base de silicium tel qu'un oxyde de silicium SiOₓ, un nitrure de silicium SiNₓ, entre autres. Des portions conductrices 12 affleurent la surface du substrat support, et assurent la connexion électrique des piliers d'ancrage 21 des détecteurs thermiques 20 au circuit de lecture. De plus, une ou plusieurs portions de connexion 13 affleurent ici la surface du substrat support, et permettent de connecter le circuit de lecture à un dispositif électronique externe.

Le substrat de lecture 11 peut comporter un réflecteur (non représenté) disposé en regard de chaque détecteur thermique 20. Le réflecteur peut être formé par une portion d'une ligne conductrice du dernier niveau d'interconnexion, celle-ci étant réalisée en un matériau adapté à réfléchir le rayonnement électromagnétique à détecter. Il s'étend en regard de la membrane absorbante 22 du détecteur thermique 20, et est destiné à former avec celle-ci une cavité interférentielle quart d'onde vis-à-vis du rayonnement électromagnétique à détecter.

Enfin, le substrat de lecture 11 comporte ici une couche de protection 14 de manière à recouvrir notamment la couche isolante inter-métal supérieure. Cette couche de protection 14 correspond ici à une couche d'arrêt de gravure réalisée en un matériau sensiblement inerte à l'agent de gravure chimique utilisé ultérieurement pour supprimer les différentes couches sacrificielles minérales 15, par exemple au milieu HF en phase vapeur. Cette couche de protection 14 forme ainsi une couche hermétique et chimiquement inerte, et électriquement isolante pour éviter tout court-circuit entre les piliers d'ancrage 21. Elle permet ainsi d'éviter que les couches isolantes inter-métal sous-jacentes ne soient gravées lors de cette étape de suppression des couches sacrificielles minérales 15. Elle peut être formée en un oxyde ou nitrure d'aluminium, voire en trifluorure d'aluminium, ou encore en silicium amorphe non intentionnellement dopé. La couche de protection 14 ne recouvre pas les portions de connexion 13, de manière à permettre une connexion électrique de celles-ci à un dispositif électrique externe.

On réalise ensuite les détecteurs thermiques 20 sur le substrat de lecture 11. Ces étapes de réalisation sont identiques ou similaires à celles décrites notamment dans le document EP3239670A1. Les détecteurs thermiques 20 sont ici des microbolomètres comportant chacun une membrane absorbante 22, i.e. apte à absorber le rayonnement électromagnétique à détecter, suspendue au-dessus du substrat de lecture 11 par des piliers d'ancrage 21, et isolée thermiquement de celui-ci par des bras de maintien et d'isolation thermique. L'obtention de membranes absorbantes 22 est classiquement obtenue par des techniques de micro-usinage de surface consistant à réaliser les piliers d'ancrage 21 au travers d'une première couche sacrificielle minérale, et les bras d'isolation thermique ainsi que les membranes absorbantes 22 sur la face supérieure de la couche sacrificielle. Chaque membrane absorbante comporte en outre un transducteur thermométrique, par exemple un matériau thermistance relié au circuit de lecture par des connexions électriques prévues dans les bras d'isolation thermique et dans les piliers d'ancrage 21.

On dépose ensuite une deuxième couche sacrificielle minérale préférentiellement de même nature que la première couche sacrificielle minérale. La deuxième couche sacrificielle minérale recouvre la couche sacrificielle minérale ainsi que les détecteurs thermiques 20. Sur les figures, les deux couches sacrificielles minérales 15 sont illustrées ensemble.

On réalise ensuite la couche mince d'encapsulation 16 d'une structure d'encapsulation de manière similaire à celle décrite dans le document EP3239670A1, ceci pour chaque matrice de détecteurs thermiques 20. Tout d'abord, par des techniques classiques de photolithographie, on grave localement les couches sacrificielles minérales 15 pour former des tranchées débouchant sur le substrat de lecture 11. On procède ensuite au dépôt conforme de la couche mince d'encapsulation 16, ici du silicium amorphe, qui s'étend sur la couche sacrificielle minérale 15 ainsi que dans les tranchées, par exemple par un dépôt chimique en phase vapeur (CVD pour *Chemical Vapor Deposition,* en anglais). Bien entendu, la couche d'encapsulation 16 peut comporter des piliers de soutien, comme le décrit notamment le document EP3067674A2.

La couche mince d'encapsulation 16 comprend donc une partie supérieure 16.1 (également appelée paroi supérieure) qui s'étend au-dessus et à distance suivant l'axe Z des détecteurs thermiques 20, et une partie périphérique 16.2 (également appelée paroi périphérique) qui entoure dans le plan XY de manière continue les détecteurs thermiques 20. La paroi supérieure 16.1 repose donc sur et au contact de la couche sacrificielle minérale 15. La couche mince d'encapsulation 16 est destinée à délimiter la cavité 2 suivant la direction +Z et dans le plan XY. La partie supérieure 16.1 et la partie périphérique 16.2 sont donc formées d'un seul tenant et en le(s) même(s) matériau(x).

Dans cet exemple, différentes couches minces d'encapsulation 16 distinctes les unes des autres sont réalisées, chacune étant propre à un dispositif de détection 1 différent. Pour cela, une même couche mince d'encapsulation 16 peut être déposée de manière à recouvrir continûment les différentes matrices de détecteurs thermiques 20 et à s'étendre dans les différentes tranchées. Elle est ensuite gravée localement pour former une ouverture périphérique 17.3 permettant de rendre distinctes les unes des autres les différentes couches minces d'encapsulation 16. Aussi, les parois supérieures 16.1 des différentes couches minces d'encapsulation 16 sont distinctes les unes des autres. Dans cet exemple, le matériau d'encapsulation ne s'étend pas au-dessus de la ou des portions de connexion 13.

En référence à la fig.1B, on réalise, par photolithographie et gravure dans la couche mince d'encapsulation 16, au moins un premier évent de libération 17.1 dit latéral, et avantageusement ici des deuxièmes évents de libération 17.2. Ces évents 17.1, 17.2 sont notamment destinés à permettre l'évacuation des différentes couches sacrificielles minérales 15 hors de la cavité 2, et sont des ouvertures traversantes réalisées au travers de la couche mince d'encapsulation 16 et débouchant sur la couche sacrificielle minérale 15 sous-jacente. Les ouvertures périphériques 17.3 peuvent être réalisées à cette étape.

L'évent latéral 17.1 est destiné à permettre l'introduction dans la cavité 2 d'au moins une portion getter 34, laquelle est fixée à une couche mince de scellement 33 reportée et assemblée par collage direct à la couche mince d'encapsulation 16. Il peut présenter des dimensions supérieures à celles des deuxièmes évents de libération 17.2, de manière à permettre l'introduction de la portion getter 34. De plus, il est dit latéral dans la mesure où il est distant des détecteurs thermiques 20 dans un plan XY parallèle au plan du substrat, c'est-à-dire qu'il est espacé d'une distance non nulle vis-à-vis d'au moins les membranes absorbantes 22, et de préférence également des bras d'isolation thermique et des piliers d'ancrage 21. Par ailleurs, il est distant des détecteurs thermiques 20 optiquement actifs, c'est-à-dire de ceux destinés à détecter le rayonnement infrarouge, de manière à ce que la présence de la portion getter 34 ne perturbe pas la transmission du rayonnement électromagnétique à détecter. En variante, comme décrit plus loin, il peut surplomber un détecteur thermique de compensation, c'est-à-dire un détecteur thermique dit aveugle dans la mesure où il est destiné à ne pas recevoir et détecter le rayonnement électromagnétique.

Les deuxièmes évents de libération 17.2 peuvent être disposés entre deux détecteurs thermiques 20 adjacents, ou être disposés en regard suivant l'axe Z des membranes absorbantes 22 comme décrit dans la demande EP3067675A1. A la différence de ce document, dans la mesure où la couche mince de scellement 33 est reportée sur la couche mince d'encapsulation 16, il n'y a pas de risque qu'un matériau de scellement tombe au travers des deuxièmes évents sur les membranes absorbantes 22. Les membranes absorbantes 22 peuvent alors ne pas comporter d'ouverture traversante située à la perpendiculaire d'un deuxième évent correspondant, tel que le décrit cette demande EP3067675A1, ce qui permet d'améliorer les performances du dispositif de détection.

On effectue ensuite une gravure chimique adaptée à supprimer les couches sacrificielles minérales 15, ici une gravure chimique humide par attaque à l'acide fluorhydrique en phase vapeur. Les produits de la réaction chimique sont évacués au travers de l'évent latéral 17.1 et des deuxièmes évents de libération 17.2. Cette gravure chimique humide étant isotrope, on obtient la suspension des membranes absorbantes 22 et des bras d'isolation thermique, et on libère les piliers d'ancrage 21. Les parties de couches sacrificielles minérales 15 situées entre les couches minces d'encapsulation 16 adjacentes, notamment celles qui recouvrent la ou les portions de connexion 13, sont également supprimées lors de cette gravure chimique, ici au travers de l'ouverture périphérique 17.3.

En référence à la fig.1C, on réalise un deuxième empilement 30 comportant :
- un substrat support ;
- une couche mince dite de scellement 33, reposant sur le substrat support, transparente au rayonnement électromagnétique à détecter ; et
- au moins une portion getter 34 disposée sur la couche mince de scellement 33, et recouvrant partiellement celle-ci.

Le deuxième empilement 30 peut être réalisé à partir d'un substrat SOI ou d'un substrat GeOI. Le substrat support est alors formé d'un substrat 31 en silicium d'une épaisseur par exemple de quelques centaines de microns d'épaisseur, et d'une couche 32 d'oxyde enterré (BOX). La couche mince de scellement 33 peut être réalisée en silicium dans le cas du substrat SOI, ou en germanium dans le cas du substrat GeOI. Le matériau et l'épaisseur de la couche mince de scellement 33 sont choisis de sorte qu'elle est transparente au rayonnement électromagnétique à détecter. Elle peut ainsi présenter une épaisseur inférieure ou égale à 200µm, voire à 10µm, de préférence inférieure ou égale à 5µm, par exemple égale à 100nm environ.

La portion getter 34 présente des dimensions et une disposition sur la couche mince de scellement 33 permettant d'être introduite au travers de l'évent latéral 17.1. Elle peut ainsi, à titre illustratif, présenter une épaisseur de l'ordre de 100nm à 1µm, typiquement 300nm et des dimensions latérales qui dépendent de l'agencement de la portion getter vis-à-vis du ou des détecteurs. Elles peuvent ainsi être de l'ordre de plusieurs mm² pour, par exemple, s'étendre à la verticale de plusieurs détecteurs de compensation, voire présenter des dimensions bien plus petites, notamment lorsqu'une grille de portions getter est prévue. Cette étape de réalisation du deuxième empilement 30 peut bien entendu être effectuée avant, pendant ou après les étapes décrites précédemment.

Dans cet exemple, la couche mince d'encapsulation 16 est formée en un seul matériau, ici en silicium amorphe, de sorte que la paroi supérieure 16.1 et la paroi périphérique sont entièrement réalisées en silicium amorphe. La couche mince de scellement 33 est également formée en un seul matériau, ici en silicium (cas du substrat SOI) ou en germanium (cas du substrat GeOI). En variante, comme décrit plus loin, la couche mince d'encapsulation 16 et la couche mince de scellement 33 peuvent être au moins localement des multicouches, les surfaces destinées à être mises en contact étant alors formées par des sous-couches métalliques.

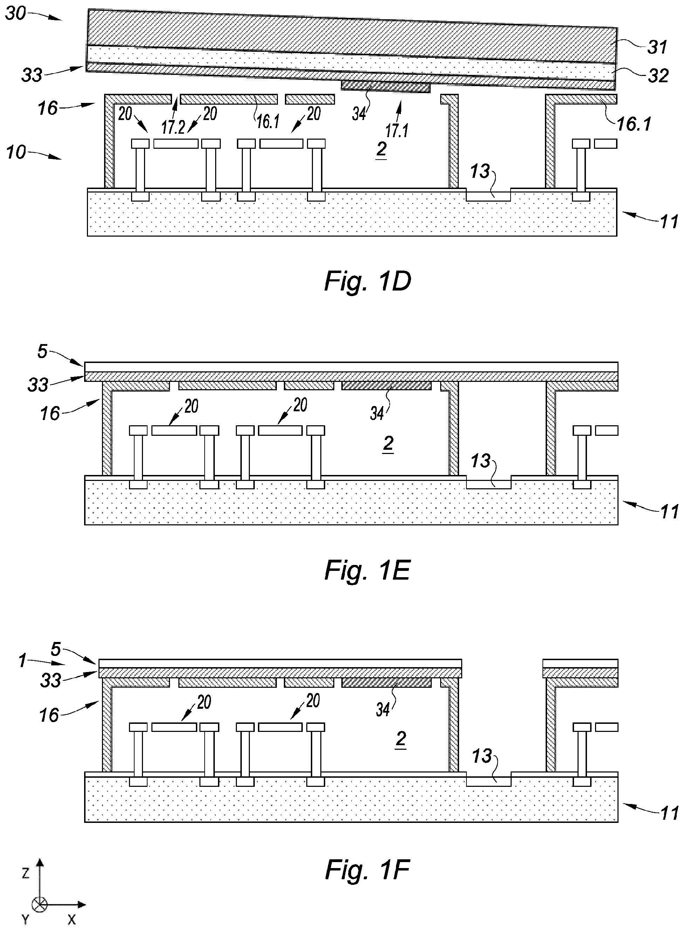

En référence à la fig.1D, on assemble le deuxième empilement 30 sur le premier empilement 10 par mise en contact et collage direct de la couche mince de scellement 33 avec la couche mince d'encapsulation 16. Dans cet exemple, la même couche mince de scellement 33 du deuxième empilement 30 est mise au contact des parties supérieures 16.1 des différentes couches minces d'encapsulation 16.

Les surfaces mises en contact mutuel et assemblées par collage direct sont sensiblement planes. Aussi, au préalable, une étape de planarisation de la couche mince d'encapsulation 16 peut être effectuée avant la réalisation des évents 17.1, 17.2 et de l'ouverture périphérique 17.3. Une étape de planarisation de la couche mince de scellement 33 peut également être effectuée avant la réalisation de la portion getter 34.

La couche mince de scellement 33 étant une couche plane et continue, elle est adaptée à obturer les évents latéraux 17.1 ainsi que les deuxièmes évents de libération 17.2, rendant ainsi hermétique la cavité 2, et ici les cavités 2 des différentes matrices de détecteurs thermiques 20. Chaque évent latéral 17.1 reçoit au moins une portion getter 34, laquelle est donc introduite dans la cavité 2 correspondante. La face de la couche mince de scellement 33 orientée vers le substrat 11 est une face plane. La couche mince de scellement 33 recouvre l'évent latéral 17.1 et ainsi l'obture sans que du matériau de scellement ne s'étende dans l'évent latéral 17.1. la face de la couche mince de scellement 33 opposée au substrat 11 est également plane.

Le collage direct est de préférence un collage dit SAB *(Surface Activated Bonding,* en anglais). Cette technique de collage est notamment adaptée au collage direct de deux couches de silicium à température ambiante, sans matériau de collage intercalaire de type résine ou polymère. Cette technique de collage est notamment décrite dans la publication de Takagi et al. intitulée Surface activated bonding of silicon wafers at room temperature, Appl. Phys. Lett. 68, 2222 (1996). Elle permet également le collage direct d'une couche mince de scellement 33 en germanium sur la couche mince d'encapsulation 16 en silicium.

Pour cela, les faces libres (surfaces de contact) en silicium des parois supérieures 16.1 et de la couche mince de scellement 33 ont été préalablement activées par gravure partielle par faisceau d'ions, par exemple par faisceau d'atomes d'argon, ou de He, Ne, Xe, Kr. Dans le cas où cette préparation de surface se traduit par une faible gravure de la surface de la portion getter 34, une couche mince de protection, par exemple d'une épaisseur de 10nm environ, peut être préalablement déposée de manière à recouvrir et donc protéger la portion getter 34. Cette couche mince de protection est alors gravée progressivement lors de cette préparation de surface, jusqu'à être totalement gravée à l'issue de cette préparation, rendant alors libre la surface de la portion getter 34.

La face libre en silicium de la couche mince de scellement 33 est donc mise directement au contact de la face supérieure en silicium de la paroi supérieure 16.1 de la couche mince d'encapsulation 16. La mise au contact des surfaces de contact en silicium est effectuée sous vide, de préférence avec une pression de niveau de vide inférieure ou égale à 10⁻⁷ mbar (soit 10⁻⁵ Pa). Une force de pression peut être exercée sur le substrat de report en direction de l'empilement capteur, par exemple comprise entre 0.05 et 1.6 MPa.

On obtient ainsi un collage direct entre les surfaces en contact par liaison covalente silicium/silicium ou silicium/germanium. L'énergie de collage est élevée du fait de la solidarisation par liaisons covalentes, et l'herméticité de la cavité 2 est donc renforcée. Une adhérence au moins égale à 2J/m² peut être obtenue à température ambiante. Un recuit de collage n'est alors pas nécessaire. Ainsi, on écarte les risques de dégradation du circuit de lecture qui seraient liés à un recuit à une température supérieure à la température du budget thermique d'un circuit de lecture CMOS contenu dans le substrat 11, qui est de l'ordre de 350°C à 400°C environ. De plus, l'interface de collage est formée ici par les surfaces silicium/silicium (ou silicium/germanium), et ne comporte pas d'oxyde susceptible de réduire la transmission du rayonnement lumineux en direction des détecteurs thermiques 20. Les performances du dispositif de détection 1 sont alors préservées.

Un écart de température peut être appliqué aux deux empilements 10, 30, afin de générer une contrainte mécanique en légère tension au sein du deuxième empilement 30, améliorant ainsi sa planéité, et réduisant la contrainte mécanique résiduelle après assemblage. Cet écart de température peut être supérieur à 0°C et inférieur ou égal à 150°C, et par exemple égal à 50°C environ, de manière à générer une contrainte en tension de l'ordre de 25MPa au sein du deuxième empilement 30.

En référence à la fig.1E, on supprime avantageusement le substrat support du deuxième empilement 30, à savoir ici le substrat en silicium 31 et la couche d'oxyde enterré 32, de manière à rendre libre la face de la couche mince de scellement 33 opposée au substrat. Pour cela, on peut réaliser une abrasion (*grinding,* en anglais) d'une partie du substrat en silicium 31, jusqu'à obtenir une couche résiduelle de quelques microns d'épaisseur, suivie d'une gravure chimique de la couche résiduelle avec arrêt de gravure sur la couche d'oxyde 32. D'autres techniques sont possibles. La couche d'oxyde 32 est ensuite supprimée, par exemple par gravure chimique à l'acide fluorhydrique en phase valeur. Ainsi, la couche mince de scellement 33 présente une face rendue libre.

On peut ensuite déposer une couche antireflet 5 sur la couche mince de scellement 33, permettant d'optimiser la transmission du rayonnement électromagnétique au travers de la structure d'encapsulation. Cette couche antireflet 5 peut être réalisée en sulfure de zinc avec une épaisseur de 1.2µm environ, ou en carbone amorphe. D'autres types de couches antireflet peuvent être utilisés, telles qu'une couche microstructurée de type *Moth Eye.*

En référence à la fig.1F, on grave ensuite localement la couche antireflet 5 et la couche mince de scellement 33 qui s'étendent au-dessus des portions de connexion 13 et relient les différentes couches minces d'encapsulation 16, de manière à donner accès aux portions de connexion 13 et à rendre possible une connexion électrique, par exemple de type filaire (*wire bonding,* en anglais) entre les portions de connexion 13 et un dispositif électrique externe.

Par ailleurs, une étape de découpe de l'empilement ainsi obtenu peut être effectuée, de manière à dissocier les différentes matrices de détecteurs thermiques 20 les unes des autres. Cette étape de découpe peut être effectuée suivant des lignes de découpe prédéfinies par les techniques connues, par exemple par découpe mécanique et/ou par laser, par gravure chimique, par gravure physique, ou autre.

Ainsi, le procédé de fabrication permet d'obtenir un dispositif de détection 1 comportant une structure d'encapsulation délimitant une cavité hermétique 2 dans laquelle se trouvent ici plusieurs détecteurs thermiques 20 ainsi qu'au moins une portion getter 34. La structure d'encapsulation est formée par une couche mince d'encapsulation 16 qui s'étend continûment au-dessus et autour des détecteurs thermiques 20, et par une couche mince de scellement 33 assemblée par collage direct à la couche mince d'encapsulation 16. Une portion getter 34 est fixée à la couche mince de scellement 33 et est introduite dans la cavité 2 lors du report, au travers de l'évent latéral 17.1 de la couche mince d'encapsulation 16, lequel est distant des détecteurs thermiques 20 optiquement actifs.

Par le fait que les couches sacrificielles minérales 15 soient supprimées avant le report de la couche mince de scellement 33 munie de la portion getter 34, la portion getter 34 est protégée de toute dégradation que pourrait lui causer la gravure chimique humide, par exemple une attaque HF vapeur, utilisée pour supprimer les couches sacrificielles minérales 15.

De plus, par le fait d'introduire la portion getter 34 dans la cavité 2 au moyen de la couche mince de scellement 33, on préserve le maintien mécanique des couches sacrificielles minérales 15 lors des étapes de planarisation des différentes couches sacrificielles minérales 15 déposées. On évite ainsi la fragilité mécanique mentionnée dans le document EP3239670A1 mise en évidence lors de la planarisation des couches sacrificielles minérales 15 lorsqu'elles reposent sur une couche mince sacrificielle carbonée tel que du polyimide, dans le cas où la portion getter 34 est située sous un détecteur thermique et est protégée de l'attaque HF vapeur par la couche carbonée en polyimide. En effet, dans le cadre de l'invention, les couches sacrificielles minérales 15 ne reposent pas sur une couche sacrificielle carbonée qui protégerait une portion getter 34 reposant sur le substrat, de sorte que cette fragilité mécanique est ici écartée.

Par ailleurs, la portion getter 34 n'est pas située en regard des membranes absorbantes 22 comme c'est le cas dans le document EP3239670A1, ce qui autorise d'utiliser une surface de matériau getter plus importante. De plus, le matériau getter peut être choisi uniquement en fonction de sa propriété de chimisorption, et non pas en fonction d'une propriété supplémentaire de réflecteur optique. Un matériau getter à haute performance de chimisorption peut donc être choisi.

L'assemblage du deuxième empilement 30 sur le premier empilement 10 ne nécessite pas d'utiliser le cuivre pour effectuer le collage direct, simplifiant ainsi le procédé de fabrication. Par ailleurs, l'assemblage par collage SAB peut être effectué à température ambiante tout en obtenant une qualité élevée d'herméticité de la cavité 2. On évite ainsi de dégrader le circuit de lecture présent dans le premier substrat, ou de provoquer une évolution non souhaitée des propriétés du matériau thermomètre utilisé dans les membranes absorbantes. L'activation du getter peut d'ailleurs être effectuée avant ou après l'étape d'assemblage.

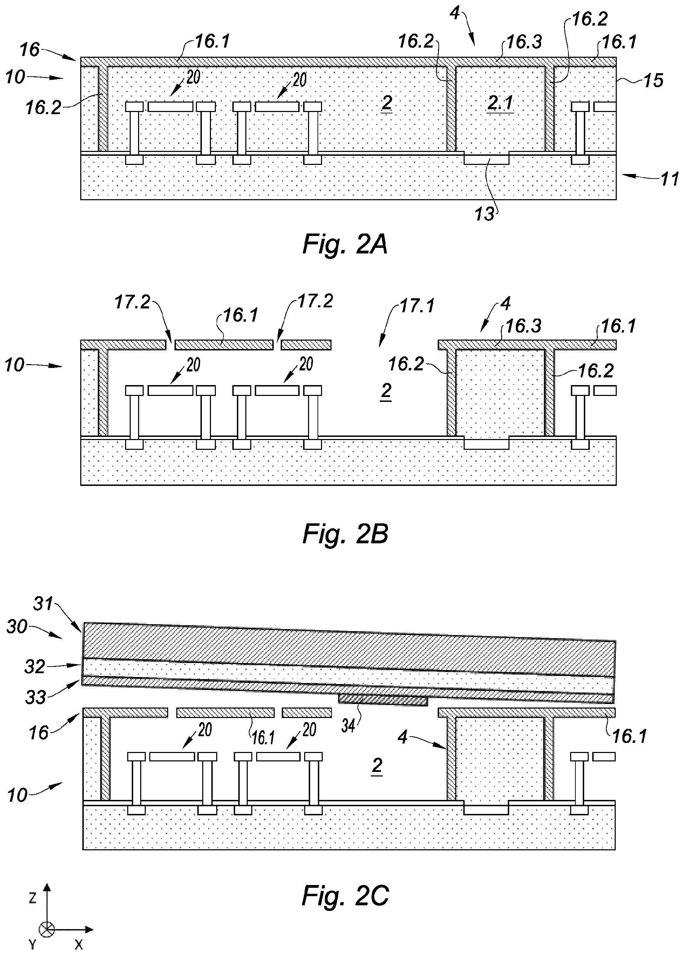

Les figures 2A à 2E illustrent différentes étapes d'un procédé de fabrication selon une variante du premier mode de réalisation. Ce procédé diffère de celui décrit précédemment essentiellement en ce qu'il comporte un plot latéral 4 provisoire situé entre les cavités 2 logeant les matrices de détecteurs thermiques 20. Ce plot latéral 4 assure un renfort mécanique lors de l'étape d'assemblage par collage direct, en particulier lorsque le collage direct est assisté en pression. De plus, il s'agit d'un plot latéral 4 dit provisoire dans la mesure où il est ensuite supprimé, ici pour permettre l'accès aux portions de connexion 13 et pour permettre la découpe de l'empilement final obtenu.

En référence à la fig.2A, on réalise un premier empilement 10 similaire à celui décrit précédemment et illustré sur la fig.1A. Il s'en distingue toutefois essentiellement en ce qu'une même couche mince d'encapsulation 16 s'étend continûment au-dessus des différentes matrices de détection. Aussi, les parois supérieures 16.1 qui s'étendent au-dessus des matrices de détecteurs thermiques 20 adjacentes sont reliées entre elles par une paroi supérieure intercalaire 16.3, laquelle surplombe ici les portions de connexion 13. Aussi, un plot latéral de renfort 4 est formé par la paroi supérieure intercalaire 16.3 et par les parois périphériques 16.2 qui délimitent des cavités 2 adjacentes. Ces parois délimitent une cavité dite latérale 2.1 remplie entièrement par les couches sacrificielles minérales 15. Le ou les portions de connexion 13 sont ici disposées dans le plot latéral de renfort 4. Celui-ci est donc disposé entre deux matrices de détecteurs thermiques 20 adjacentes. Il peut s'étendre de manière à entourer au moins en partie une même matrice de détecteurs thermiques 20.

En référence à la fig.2B, on réalise le ou les évents latéraux 17.1 ainsi que les deuxièmes évents de libération 17.2 dans les parois supérieures 16.1 s'étendant au-dessus des matrices de détecteurs thermiques 20. Ici cependant, l'ouverture périphérique 17.3 n'est pas réalisée à ce stade, de sorte que le plot latéral de renfort 4 reste intact. Une gravure chimique humide, par exemple à l'HF vapeur, est ensuite effectuée pour supprimer les parties de couche sacrificielle minérale 15 situées sous les parois supérieures 16.1 dans les cavités 2. En revanche, la partie de couche sacrificielle minérale 15 située dans le plot latéral de renfort 4 n'est pas supprimée, dans la mesure où elle est protégée de l'attaque chimique par les parois périphériques 16.2 et par la paroi supérieure intercalaire 16.3.

En référence à la fig.2C, après avoir réalisé le deuxième empilement 30 tel que décrit précédemment (fig.1C), on assemble le deuxième empilement 30 sur le premier empilement 10 par mise en contact et collage direct de la couche mince de scellement 33 avec la couche mince d'encapsulation 16. La couche mince de scellement 33 vient donc au contact des parois supérieures 16.1 situées au-dessus des matrices de détecteurs thermiques 20, ainsi que de la paroi supérieure intercalaire 16.3. Le plot latéral de renfort 4 permet d'améliorer la tenue mécanique de la couche mince d'encapsulation 16 lors du collage direct, ce qui est particulièrement avantageux lorsque le collage direct est assisté en pression, comme décrit précédemment.

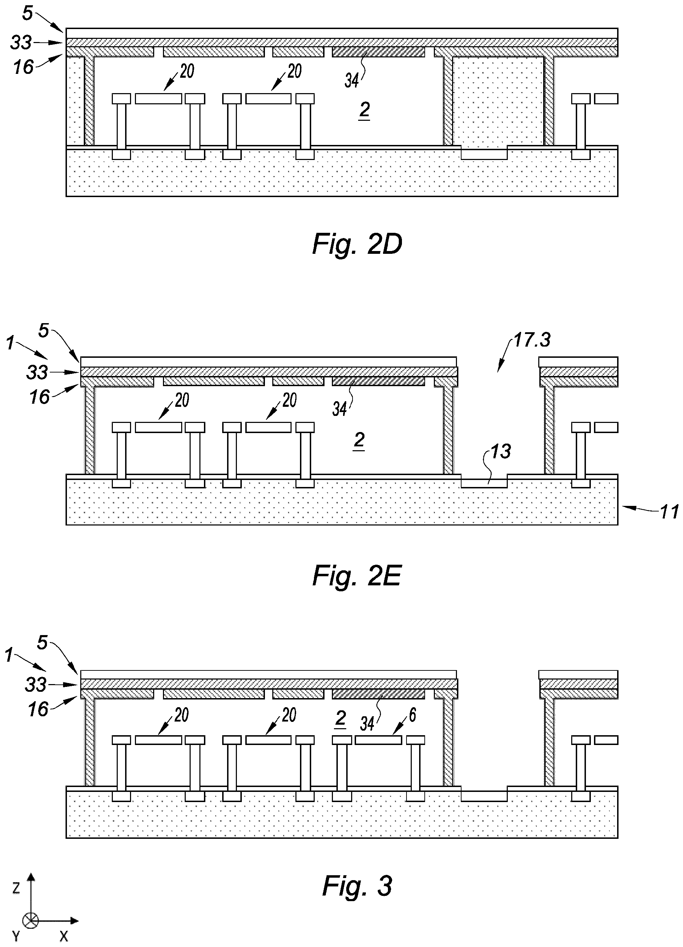

En référence à la fig.2D, on supprime le substrat support du deuxième empilement 30, à savoir ici le substrat en silicium 31 et la couche d'oxyde enterré 32, de manière à rendre libre une face de la couche mince de scellement 33. On dépose ainsi la couche antireflet 5 sur la face rendue libre de la couche mince de scellement 33. Ces étapes sont ici identiques à celles décrites en référence à la fig.1E.

En référence à la fig.2E, on réalise la ou les ouvertures périphériques 17.3 au travers de l'empilement formé de la couche antireflet 5, de la couche mince de scellement 33, et de la couche mince d'encapsulation 16. La paroi supérieure intercalaire 16.3 est donc au moins en partie supprimée, donnant ainsi accès aux couches sacrificielles minérales 15. Les couches sacrificielles minérales 15 formant le plot latéral 4 sont ensuite supprimées, par exemple par attaque chimique à HF vapeur. On rend ainsi libres d'accès la ou les portions de connexion 13. L'empilement ainsi obtenu peut ensuite être découpé, de manière à dissocier les différentes matrices de détecteurs thermiques 20 les unes des autres.

Le procédé de fabrication selon cette variante permet ainsi de mettre à profit la présence temporaire d'un plot latéral de renfort dans le premier empilement 10 pour renforcer la tenue mécanique de la couche mince d'encapsulation 16 lors de l'assemblage par collage direct du deuxième empilement 30 sur le premier empilement 10.

La figure 3 est une vue en coupe, schématique et partielle, d'un dispositif de détection 1 obtenu par un procédé de fabrication selon une autre variante du premier mode de réalisation.

Ici, le dispositif de détection 1 diffère de ceux décrits précédemment essentiellement en ce qu'il comporte au moins un détecteur thermique de compensation 6, disposé dans une cavité hermétique 2, en regard duquel est disposé la portion getter 34. Ainsi, la portion getter 34 est disposée à distance des détecteurs thermiques 20 destinés à détecter le rayonnement électromagnétique, de manière à ne pas perturber la transmission du rayonnement électromagnétique en direction de ces détecteurs thermiques 20. Cependant, il est disposé en regard du détecteur thermique de compensation 6, et notamment en regard de toute sa membrane suspendue, de manière à bloquer la transmission du rayonnement électromagnétique en direction de ce détecteur thermique 6. La portion getter 34 est donc réalisée en un matériau et d'une épaisseur tels qu'elle ne transmet pas le rayonnement électromagnétique à détecter. Autrement dit, la portion getter 34 est opaque au rayonnement électromagnétique à détecter.

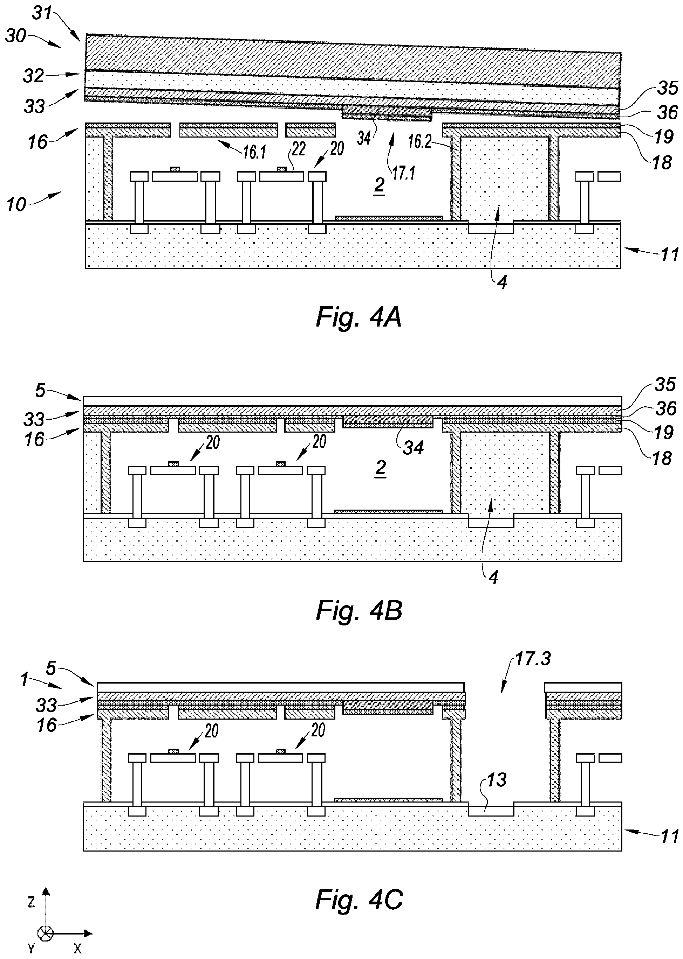

Les figures 4A à 4C illustrent différentes étapes d'un procédé de fabrication selon un deuxième mode de réalisation dans lequel le collage direct est de type ADB (*Atomic Diffusion Bonding*). Cette technique de collage est notamment adaptée au collage de deux couches métalliques à température ambiante, sans matériau de collage intercalaire de type résine ou polymère. Elle est notamment décrite dans la publication de Shimatsu et Uomoto intitulée Atomic diffusion bonding of wafers with thin nanocrystalline metal films, J. Vac. Sci. Technol. B 28, 706 (2010).

Pour cela, les surfaces de collage de la couche mince d'encapsulation 16 et de la couche mince de scellement 33 sont formées par des sous-couches métalliques 19, 36, de préférence en titane Ti, d'une épaisseur choisie pour limiter l'absorption du rayonnement électromagnétique à détecter, par exemple d'une épaisseur inférieure ou égale à 1nm dans le cas du titane. Le matériau de ces sous-couches métalliques 19, 36 est de préférence un matériau à effet getter, et est de préférence identique à celui de la portion getter 34.

En référence à la fig.4A, on réalise un premier empilement 10 ici similaire à celui décrit en référence aux fig.2A-2E dans le sens où il comporte ici une portion latérale de renfort 4. Cependant, le premier empilement 10 peut ne pas comporter cette portion latérale, comme décrit en référence aux fig. 1A-1F. Après réalisation des évents de libération et suppression des couches sacrificielles minérales 15, on dépose une couche mince métallique 19, par exemple ici du titane d'une épaisseur de 0.5nm déposée par dépôt physique en phase vapeur (évaporation, pulvérisation...) sous vide, par exemple avec une pression inférieure ou égale à 2×10⁻⁶Pa. La paroi supérieure 16.1 de la couche mince d'encapsulation 16 est donc formée d'une sous-couche 18, par exemple en silicium, réalisée d'un seul tenant avec la paroi périphérique 16.2, et d'une sous-couche métallique 19. Du titane peut ici être déposé sur les membranes absorbantes 22 ainsi que sur le substrat de lecture 11. Cependant, le surplus de masse thermique est négligeable et les risques de court-circuit électrique sont écartés. Dans cet exemple, il est avantageux qu'il n'y ait pas de détecteur thermique de compensation sous l'évent latéral 17.1.

On réalise un deuxième empilement 30 similaire à celui décrit précédemment. Cependant, une deuxième sous-couche métallique 36, de préférence identique en épaisseur et en matériau à la première sous-couche métallique 19, est déposée sur une sous-couche 35 de la couche mince de scellement 33 et ici sur la portion getter 34. Il s'agit ici d'une couche mince 36 de titane d'une épaisseur de 0.5nm environ. Plus précisément, la couche mince de scellement 33 est formée d'une sous-couche 35 en silicium (substrat SOI) ou en germanium (substrat GeOI) et d'une deuxième sous-couche métallique 36.

Puis le deuxième empilement 30 est assemblé sur le premier empilement 10, par mise en contact des deux sous-couches métalliques 19, 36, à température ambiante, et sous vide. Ces sous-couches métalliques 19, 36 étant formées d'un métal nanocristallin, c'est-à-dire cristallin d'une épaisseur de l'ordre de, au plus, quelques nanomètres, le collage direct entre ces deux surfaces métalliques est obtenu. La diffusion atomique à l'interface de collage permet d'obtenir une herméticité renforcée de la cavité 2.

En référence à la fig.4B, on supprime ensuite le substrat support 31, 32 et on dépose une couche antireflet 5 sur la face libre de la couche mince de scellement 33. Cette étape est identique à celles décrites précédemment et n'est pas détaillée de nouveau.

En référence à la fig.4C, on supprime le plot latéral de renfort 4, de manière à donner accès au(x) portion(s) de connexion 13 et permettre la découpe de l'empilement obtenu.

Des modes de réalisation particuliers viennent d'être décrits. Différentes variantes et modifications apparaîtront à l'homme du métier.

Ainsi, dans la mesure où les évents de libération sont obturés par la couche mince de scellement 33, laquelle est reportée et non pas directement formée sur la couche mince d'encapsulation 16 par dépôt de type évaporation ou pulvérisation, les deuxièmes évents peuvent présenter des dimensions plus importantes que dans l'art antérieur. En effet, ces dimensions ne sont plus contraintes par la nécessité d'être facilement obturables par la couche mince déposée. On accélère ainsi la vitesse de libération du matériau des couches sacrificielles minérales 15 hors de la cavité 2. De plus, le niveau de vide avant activation du getter peut être plus poussé que dans les structures de l'état de l'art, ce qui peut permettre de réduire la surface nécessaire de la portion getter 34.

La surface de la couche mince de scellement 33 située en regard des détecteurs thermiques 20 peut présenter une fonction optique supplémentaire. Ainsi, elle peut comporter des portions texturées formant chacune par exemple un filtre optique, une portion antireflet etc. Ces portions texturées peuvent être réalisées sur la couche mince de scellement 33 avant l'étape d'assemblage par collage direct, puis disposées dans la cavité 2 au travers d'un deuxième évent après l'étape d'assemblage. Un exemple de telles portions texturées est donné dans le document EP3399920A1. Ces portions texturées peuvent, en variante, être réalisées sur la face libre de la couche mince de scellement 33, après l'étape d'assemblage par collage direct. Il est également possible de structurer la face inférieure de la couche mince d'encapsulation 16, notamment comme le décrit le document EP3196615, pour lui ajouter une fonction optique (antireflet...), améliorant ainsi les performances du dispositif de détection.

## Revendications

1. Procédé de fabrication d'un dispositif de détection (1) d'un rayonnement électromagnétique, comportant les étapes suivantes :
∘ réalisation d'un premier empilement (10) comportant :
• un premier substrat (11),
• au moins un détecteur thermique (20) reposant sur le premier substrat (11), destiné à détecter le rayonnement électromagnétique, et recouvert par au moins une couche sacrificielle minérale (15) réalisée en un matériau minéral apte à être supprimé par une gravure chimique,
• une couche mince d'encapsulation (16), s'étendant au-dessus du détecteur thermique (20) et participant à délimiter une cavité (2) dans laquelle se situe le détecteur thermique (20), comportant une partie supérieure (16.1) reposant sur la couche sacrificielle minérale (15) ;
∘ réalisation d'au moins un évent dit latéral (17.1) s'étendant au travers de la couche mince d'encapsulation (16), et étant distant du détecteur thermique (20) dans un plan parallèle au plan du premier substrat (11) ;
∘ suppression par la gravure chimique de la couche mince sacrificielle (15), celle-ci étant évacuée au travers de l'évent latéral (17.1) ;
∘ **caractérisé en ce qu'**il comporte les étapes suivantes :
∘ réalisation d'un deuxième empilement (30) comportant :
• un substrat support (31, 32),
• une couche mince dite de scellement (33), transparente au rayonnement électromagnétique, et
• au moins une portion getter (34) disposée sur la couche mince de scellement (33) et recouvrant partiellement celle-ci ;
∘ assemblage des premier et deuxième empilements (10, 30), à la suite de l'étape de suppression, par mise en contact et collage direct de la couche mince de scellement (33) sur la partie supérieure (16.1) de la couche mince d'encapsulation (16), de sorte que la portion getter (34) est située dans l'évent latéral (17.1), lequel est alors obturé par la couche mince de scellement (33).

2. Procédé selon la revendication 1, dans lequel l'étape d'assemblage par collage direct est effectuée à température ambiante avec une pression de niveau de vide inférieure ou égale à 10⁻⁵ Pa.

3. Procédé selon la revendication 1 ou 2, dans lequel le premier empilement (10) comporte une matrice de détecteurs thermiques (20) situés dans la cavité (2), comportant une étape de réalisation d'une pluralité de deuxièmes évents de libération (17.2), la couche mince de scellement (33) obturant également les deuxièmes évents de libération (17.2).

4. Procédé selon l'une quelconque des revendications 1 à 3, dans lequel la couche mince d'encapsulation (16) est réalisée à base de silicium, et la couche mince de scellement (33) est réalisée à base de silicium ou de germanium.

5. Procédé selon l'une quelconque des revendications 1 à 4, dans lequel la couche mince d'encapsulation (16) présente une surface de contact en silicium, et la couche mince de scellement (33) présente une surface de contact en silicium ou en germanium, et dans lequel l'étape d'assemblage par collage direct comporte une activation desdites surfaces de contact par gravure partielle par faisceau d'ions et un collage sous vide.

6. Procédé selon l'une quelconque des revendications 1 à 4, dans lequel la partie supérieure (16.1) de la couche mince d'encapsulation (16) est formée d'une sous-couche (18) réalisée en silicium et d'une première sous-couche métallique (19), et la couche mince de scellement (33) étant formée d'une sous-couche (35) réalisée à base de silicium ou en germanium et d'une deuxième sous-couche métallique (36), les deux sous-couches métalliques (19, 36) étant transparentes au rayonnement électromagnétique à détecter, et dans lequel l'étape d'assemblage par collage direct comporte la mise en contact des deux sous-couches métalliques (19, 36) l'une contre l'autre sous vide.

7. Procédé selon la revendication 6, dans lequel lesdites sous-couches métalliques (19, 36) présentent chacune une épaisseur inférieure ou égale à 1nm.

8. Procédé selon la revendication 6 ou 7, dans lequel lesdites sous-couches métalliques (19, 36) sont réalisées en un matériau identique à celui de la portion getter (34).

9. Procédé selon l'une quelconque des revendications 1 à 8, dans lequel le premier empilement (10) comporte plusieurs matrices de détecteurs thermiques (20), chaque matrice étant située dans une cavité distincte (2) délimitée au moins en partie par une couche mince d'encapsulation (16), la couche mince de scellement (33) venant au contact des parties supérieures (16.1) des différentes couches minces d'encapsulation (16) de manière à obturer les différents évents latéraux (17.1) correspondants.

10. Procédé selon la revendication 9, dans lequel le premier empilement (10) comporte un plot latéral de renfort (4), formée d'une cavité latérale (2.1) délimitée dans le plan parallèle au substrat par des parties périphériques (16.2) de couches minces d'encapsulation (16) adjacentes, et délimitée suivant l'axe orthogonal au premier substrat (11) par une partie supérieure intercalaire (16.3) reliant les parties supérieures (16.1) des couches minces d'encapsulation (16) adjacentes, ladite cavité latérale (2.1) étant remplie par la couche sacrificielle minérale (15), renforçant ainsi la tenue mécanique des couches minces d'encapsulation (16) lors de l'assemblage desdits empilements (10, 30) par collage direct.

11. Procédé selon la revendication 10, dans lequel le plot latéral de renfort (4) est supprimé après l'étape d'assemblage par collage direct, par gravure de la partie supérieure intercalaire (16.3) et suppression par gravure chimique de la couche sacrificielle minérale (15) située dans la cavité latérale (2.1).

12. Procédé selon l'une quelconque des revendications 1 à 11, dans lequel la portion getter (34) est disposée en regard d'un détecteur thermique dit de compensation (6) destiné à ne pas recevoir le rayonnement électromagnétique, la portion getter (34) étant opaque au rayonnement électromagnétique.

13. Dispositif de détection (1) d'un rayonnement électromagnétique, comportant :
∘ un substrat (11) ;
∘ au moins un détecteur thermique (20) reposant sur le premier substrat (11), destiné à détecter le rayonnement électromagnétique ;
∘ une couche mince d'encapsulation (16), s'étendant continûment au-dessus et autour du détecteur thermique (20) et participant à délimiter une cavité (2) dans laquelle se situe le détecteur thermique (20), comportant une partie supérieure (16.1) s'étendant au-dessus du détecteur thermique (20), et une partie périphérique (16.2) s'étendant autour du détecteur thermique (20) dans un plan parallèle au substrat (11) ;
∘ au moins un évent dit latéral (17.1) s'étendant au travers de la partie supérieure (16.1) de la couche mince d'encapsulation (16), et étant distant du détecteur thermique (20) dans un plan parallèle au plan du substrat (11) ;
∘ une couche mince de scellement (33), transparente au rayonnement électromagnétique, reposant au contact de la partie supérieure (16.1) de la couche mince d'encapsulation (16) et fixée à celle-ci par collage direct, et obturant l'évent latéral (17.1), la couche mince de scellement (33) présentant une face supérieure plane opposée au substrat (11) ;
∘ au moins une portion getter (34) assemblée à la couche mince de scellement (33) et recouvrant partiellement celle-ci, et disposée dans l'évent latéral (17.1).
